# EUROPÄISCHE PATENTANMELDUNG

(11) **EP 1 047 166 A2**
(43) Veröffentlichungstag der Anmeldung: **25.10.2000**
(21) Anmeldenummer: 00106181.1
(22) Anmeldetag: 21.03.2000
(51) Int. Cl.: H02B 1/30

(54) **Bedienstand für eine Tablettenpressvorrichtung**

(30) Priorität: 22.04.1999 DE 19918298
(71) Anmelder: Fette, Wilhelm, 21493 Schwarzenbek (DE)
(72) Erfinder: Hinzpeter, Jürgen, 21493 Schwarzenbek (DE); Zeuschner, Ulrich, 21493 Schwarzenbek (DE); Wittenberg, Elke, 21483 Gülzow (DE); Lüneburg, Peter, 23919 Berkenthin (DE); Pierags, Hans-Joachim, 23820 Reinsbek (DE); Petersen, Nils, 21522 Hohnstorf (DE); Arndt, Ulrich, 21481 Lauenburg (DE); Wolf, Hans, 21493 Schwarzenbek (DE)
(74) Vertreter: Patentanwälte Hauck, Graalfs, Wehnert, Döring, Siemons

(57) **Zusammenfassung**

Bedienstand für eine Tablettenpreßvorrichtung, der einen Prozeßrechner mit Bildschirm und eine Eingabetastatur und ggf. einen Drucker aufweist, wobei das Bedienpult höhenverstellbar an einem fahrbaren Untersatz gelagert und zwischen Untersatz und Bedienpult ein linearer Verstellantrieb mit linearer Führung angeordnet ist.

## Beschreibung

Die Erfindung bezieht sich auf einen Bedienstand für eine Tablettenpreßvorrichtung nach dem Oberbegriff des Patentanspruchs 1.

Tablettenpressen weisen üblicherweise mehrere Aggregate auf, zumindest eine Presse, vorzugsweise Rundläuferpresse in einem Gehäuse mit den zugehörigen Antriebs- und Steueraggregaten, einen Schaltschrank und ein Bedientableau, das einen Prozeßrechner enthält zur Bedienung und Steuerung der Tablettenpresse. Herkömmlicherweise ist das Bedientableau mit den Bedienelementen fest an der Tablettiermaschine angeordnet. Es ist auch bereits bekannt, einen separaten Bedienstand vorzusehen, der einen mehr oder weniger großen Abstand zur Tablettenpresse hat.

Aufgrund unterschiedlicher Körpergrößen der Bediener ist die Bedienung und Betrachtung des Bedienpaneels und/oder des Bildschirms von unterschiedlicher Annehmlichkeit. Insbesondere die Betrachtung des Bildschirms kann problematisch sein, wenn er in unzweckmäßiger Höhe angeordnet ist.

Der Erfindung liegt die Aufgabe zugrunde, einen Bedienstand für eine Tablettenpreßvorrichtung zu schaffen, welcher eine auf den Bediener abgestellte individuelle Einstellung zuläßt.

Diese Aufgabe wird durch die Merkmale des Patentanspruchs 1 gelöst.

Bei der Erfindung ist ein Bedienpult höhenverstellbar auf einem fahrbaren Untersatz gelagert. Der Bediener kann mithin das Pult an einem gewünschten Ort aufstellen und den Aufstellort je nach den Betriebsbedingungen verlagern. Erfindungswesentlich ist ferner, daß zwischen dem eigentlichen Bedienpult und dem fahrbaren Untersatz ein linearer Verstellantrieb angeordnet ist. Dieser Verstellantrieb ist so ausgebildet, daß er entweder gleichzeitig eine lineare starre Führung aufweist oder mit einer linearen starren Führung zusammenwirkt. Dadurch bildet die Führung zugleich die stabile Verbindung und Abstützung zwischen Bedienpult und Untersatz. Schwankungen des Bedienpults gegenüber dem Untersatz werden ebenso vermieden wie ein Klemmen bei einer Höhenverstellung.

Der Linearantrieb ist vorzugsweise elektrisch, enthält mithin einen elektrischen Motor, dessen Drehbewegung in eine lineare umgesetzt wird. Derartige Verstellantriebe sind im Stand der Technik an sich bekannt.

Die Ansteuerung des linearen Verstellantriebs erfolgt über das Bedienpult bzw. den Prozeßrechner, in dem der Bediener z.B. die Eingabetastatur oder einen Touch-Screen betätigt.

Im Prozeßrechner ist eine Mehrzahl von Höheneinstellungen gespeichert, die bestimmten Bedienern zugeordnet sind. Durch Eingabe zum Beispiel eines Paßwortes über die Tastatur oder den Touch-Screen verstellt der Prozeßrechner das Bedienpult automatisch und bringt es auf die individuelle Höhe.

Nach einer Ausgestaltung der Erfindung ist an der Unterseite des Bedienpults ein säulenartiger Verkleidungsabschnitt angeordnet, der mit einem säulenartigen Verkleidungsabschnitt des Untersatzes teleskopisch zusammenwirkt. Der lineare Verstellantrieb wird mithin von den Verkleidungsabschnitten umgeben und ist daher gegen mechanische Einwirkungen und Staub wirksam geschützt.

Der fahrbare Untersatz weist vorzugsweise eine Reihe von Rollen auf. Mindestens eine Rolle kann mit einer elektromagnetisch betätigbaren Bremse versehen werden, die durch einen Steuerbefehl, der z.B. über die Tastatur oder den Touch-Screen eingegeben wird, betätigt bzw. gelöst werden kann.

Der konstruktive Aufbau des Bedienpultes kann verschiedenartig sein. Besonders vorteilhaft ist die Anordnung eines pultartigen Gehäuseabschnitts, an dessen Rückseite ein leicht nach hinten geneigter flacher Gehäuseabschnitt angeordnet ist, an dessen dem pultartigen Gehäuseabschnitt zugekehrter Fläche ein Touch-Screen und eine Eingabetastatur angeordnet sind. Der pultartige Gehäuseabschnitt kann den eigentlichen Rechner und ggf. einen Drucker aufnehmen.

Die Erfindung wird nachfolgend anhand eines in einer Zeichnung dargestellten Ausführungsbeispiels näher erläutert.

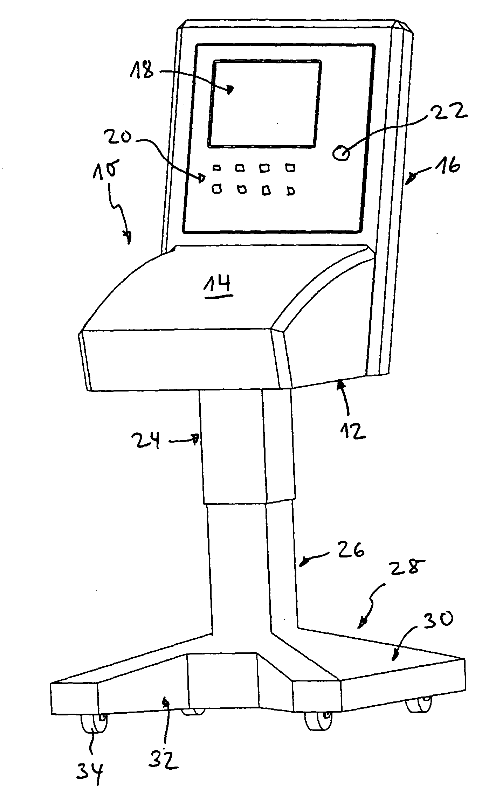

Die einzige Figur zeigt perspektivisch ein Bedienpult nach der Erfindung.

Das Bedienpult 10 nach der Figur weist einen pultartigen Gehäuseabschnitt 12 auf mit einer leicht konvex gewölbten Pultfläche 14. An der Rückseite des pultartigen Gehäuseabschnitts 12 ist ein flacher Gehäuseabschnitt 16 angeordnet, der gegenüber der Vertikalen nach hinten leicht geneigt ist und an seiner dem pultartigen Gehäuseabschnitt 12 zugewandten Seite einen Touch-Screen, eine Eingabetastatur 20 sowie einen Notausschalter 22 aufweist. Der pultartige Gehäuseabschnitt 14 kann neben einem Rechner auch einen Drucker enthalten, was jedoch nicht gezeigt ist. Das Bedienpult 10 dient insgesamt zur Bedienung einer nicht gezeigten Tablettenpresse, die zum Beispiel eine Rundläuferpresse enthält. Derartige Tablettiermaschinen sind allgemein bekannt und werden etwa in der Pharmaindustrie in großem Umfang eingesetzt.

Unterhalb des pultartigen Gehäuseabschnitts 12 ist ein säulenartiger Verkleidungsabschnitt 24 angebracht, der mit einem säulenartigen Verkleidungsabschnitt 26 eines fahrbaren Untersatzes 28 teleskopisch zusammenwirkt. Innerhalb der Verkleidungsabschnitte 24, 26 befindet sich ein linearer Verstellantrieb mit einer starren linearen Führung zur Höhenverstellung des Bedienpultes 10 relativ zum fahrbaren Untersatz 28. Der Verstellantrieb ist ebenso wenig gezeigt wie seine Verbindung mit dem zu betätigenden Teil. Die Steuerung des Verstellantriebs erfolgt wahlweise über die Tastatur 20 oder den Touch-Screen 18, wobei im Prozeßrechner Werte eingespeichert werden können, die bestimmten Bedienungspersonen zugeordnet sind. Durch Eingabe eines bestimmten Datums, das für die Bedienungsperson charakteristisch ist, wird das Bedienpult 10 auf die optimale Höhe gefahren, indem der Prozeßrechner einen entsprechenden Steuerbefehl auf den Verstellantrieb gibt. Dadurch ist es möglich, das Bedienpult ergonomisch auf den jeweiligen Bediener einzustellen, der bekanntlich die Pressenvorrichtung stehenderweise überwacht und bedient.

Der fahrbare Untersatz 28 weist eine Verkleidung 30 auf, die aus einem vierseitigen pyramidenartigen Dachabschnitt und einem darunter angeordneten flachen Kastenabschnitt besteht, der an der Vorderseite, d.h. unterhalb des Gehäuseabschnitts 14 eine trapezförmige Aussparung 32 aufweist. Diese ermöglicht das nahe Herantreten der Bedienungsperson, ohne durch den Untersatz 28 bzw. die Verkleidung 30 gestört zu sein. An den vier Ecken des Untersatzes 28 sind Rollen 34 vorgesehen, wobei mindestens einer Rolle 34 eine Bremse zugeordnet sein kann, die jedoch nicht gezeigt ist. Die Bremse ist vorzugsweise elektromagnetisch betätigbar und über den Prozeßrechner im Bedienstand ansteuerbar, beispielsweise durch Betätigung der Tastatur 20 oder des Touch-Screens 18.

## Patentansprüche

1. Bedienstand für eine Tablettenpreßvorrichtung, der einen Prozeßrechner mit Bildschirm und eine Eingabetastatur und ggf. einen Drucker aufweist mit
- einem Bedienpult (10), das höhenverstellbar an einem fahrbaren Untersatz (28) gelagert ist
- einem linearen Verstellantrieb mit vorzugsweise linearer Führung, wobei
- der Verstellantrieb über den Prozeßrechner ansteuerbar ist und
- im Prozeßrechner unterschiedliche Werte für die Höhe des Bedienpults (10) speicherbar und bedienerbezogenen Daten zuordbar sind derart, daß das Bedienpult (10) auf eine vorgegebene Höhe gefahren wird, wenn ein personenbezogenes Datum eingegeben wird.

2. Bedienstand nach Anspruch 1, bei dem an der Unterseite des Bedienpults (10) ein säulenartiger Verkleidungsabschnitt (24) angeordnet ist, der mit einem säulenartigen Verkleidungsabschnitt (26) des Untersatzes (28) teleskopisch zusammenwirkt.

3. Bedienstand nach Anspruch 2, bei dem die säulenartigen Verkleidungsabschnitte (24, 26) im Querschnitt quadratisch sind.

4. Bedienstand nach einem der Ansprüche 1 bis 3, bei dem der Verstellantrieb durch Betätigung der Tastatur (20) oder eines Touch-Screens (18) des Prozeprechners ansteuerbar ist.

5. Bedienstand nach einem der Ansprüche 1 bis 4, bei dem mindestens eine Rolle (34) des Untersatzes (28) eine elektromagnetisch betätigbare Bremse aufweist, die durch einen in den Prozeßrechner eingegebenen Steuerbefehl betätigbar bzw. lösbar ist, vorzugsweise über die Tastatur (20) oder einen Touch-Screen (18).

6. Bedienstand nach einem der Ansprüche 1 bis 5, bei dem ein pultartiger Gehäuseabschnitt (12) vorgesehen ist, an dessen Rückseite ein leicht nach hinten geneigter flacher Gehäuseabschnitt (16) angeordnet ist, der nach oben über den pultartigen Gehäuseabschnitt (12) hinaussteht und an dessen dem pultartigen Gehäuseabschnitt (12) zugeordneten Fläche ein Touch-Screen (18) und eine Eingabetastatur (20) angeordnet sind.
